# EUROPEAN PATENT APPLICATION

(11) **EP 0 820 101 A2**
(43) Date of publication of application: **21.01.1998**
(21) Application number: 97112177.7
(22) Date of filing: 16.07.1997
(51) Int. Cl.: H01L 27/108, H01L 21/8242

(54) **Semiconductor memory device with peripheral region**

(30) Priority: 16.07.1996 JP 186091/96
(71) Applicant: NEC CORPORATION, Tokyo (JP)
(72) Inventor: Yajima, Takashi, c/o NEC Corporation, Minato-ku, Tokyo (JP)
(74) Representative: Glawe, Delfs, Moll & Partner

(57) **Abstract**

In a semiconductor memory including a memory cell array zone and a peripheral circuit zone formed on the same semiconductor substrate, an interlayer insulating layer extends over the memory cell array zone and the peripheral circuit zone. The memory cell array zone includes a plurality of memory cells each having a stacked capacitor, and each stacked capacitor is formed of a capacitor dielectric film sandwiched between a capacitor lower electrode and a capacitor upper electrode, and is formed only in the memory cell array zone. The peripheral circuit zone includes a conducting layer formed on only a portion of the interlayer insulating layer within the peripheral circuit zone.

## Description

### Background of the Invention

### Field of the invention

The present invention relates to a semiconductor memory of a stacked capacitor type, and more specifically to a semiconductor memory of a stacked capacitor type, having a step or difference in height between a memory cell array zone and a peripheral circuit zone, and a method for manufacturing the same.

### Description of related art

The integration density of semiconductor memories is increasing more and more. A capacitor structure for realizing a high integration density, has recently adopted, in place of a surface structure, a three-dimensional structure in order to obtain a large capacitance with a small area. The three-dimensional capacitor structure includes a so called stacked capacitor.

Furthermore, in order to obtain a large capacitance with a small area, the capacitor structure has a tendency to increase its height. As a result, a step or difference in height at a boundary between a memory cell array zone including the memory capacitors and a peripheral circuit zone including a sense amplifier for amplifying a stored information, tends to increase. Furthermore, in order to reduce a resistance of a word line formed of polysilicon, an aluminum wiring layer is formed with the same pitch as that of the word line in the memory cell zone, and electrically connected to the word line through contacts which are formed with intervals corresponding to some number of bits. This wiring layer is called a "backing conducting layer".

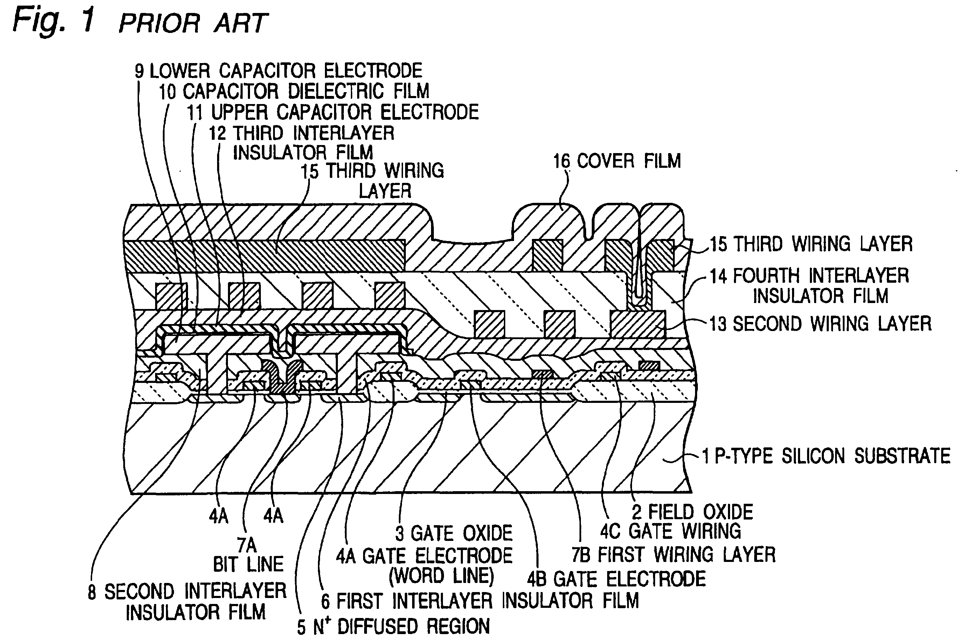

Referring to Fig. 1, there is shown a diagrammatic sectional view of a first example of the prior art semiconductor memory. As shown in Fig. 1, a field oxide film 2 is formed on a principal surface of a P-type silicone substrate 1 to confine a device formation region, namely, an active region, and a gate oxide film 3 is formed on the silicone substrate 1 within the active region.

In the memory cell array zone, there are provided a gate electrode (word line) 4A of a switching transistor for reading and writing information from and into a memory cell, a bit line 7A for transferring a potential of stored information, and a capacitor composed of a lower capacitor electrode 9 and an upper capacitor electrode 11 sandwiching a capacitor dielectric layer 10 therebetween.

In the peripheral circuit zone, there are provided a gate electrode 4B of a transistor and a gate wiring layer 4C which are the same level as that of the gate electrode (word line) 4A of the above mentioned switching transistor, a first level wiring layer 7B which is the same level as that of the bit line 7A.

Furthermore, a second wiring layer 13 and a third wiring layer 15 which extends over the memory cell array zone and the peripheral circuit zone, as shown in Fig. 1. Here, the second wiring layer 13 in the memory cell array zone is formed with the same pitch as that of the gate electrode (word line) 4A, and electrically connected to the gate electrode (word line) 4A through contact holes (not shown) which are formed, with intervals corresponding to some number of bits, to penetrate through the interlayer insulator films 12, 8 and 6.

In order to manufacturing the semiconductor memory shown in Fig. 1, firstly, the field oxide film 2 is formed on the P-type silicon substrate 1, and then, the gate oxide film 3 is formed. Thereafter, the gate electrode (word line) 4A in the memory cell array zone and the gate electrode 4B and the gate wiring layer 4C in the peripheral circuit zone are formed. Furthermore, by using the gate electrodes 4A and 4B and the field oxide film 2 as a mask, N-type impurity ions (for example, As ions) are ion-implanted into the substrate to form diffused regions 5. A first interlayer insulator film 6 is formed to cover the whole surface of the substrate, and the bit line 7A and the first level wiring layer 7B are formed on the first interlayer insulator film 6.

Then, a second interlayer insulator film 8 is formed to cover the whole surface of the substrate. In only the memory cell array zone, a contact hole is formed to reach one of a pair of diffused regions 5 of the switching transistor, and the lower capacitor electrode 9 is formed on the second interlayer insulator film 8 and to electrically connect through the contact hole to the one diffused region 5. Thereafter, the capacitor dielectric layer 10 is formed to cover the lower capacitor electrode 9, and then, the upper capacitor electrode 11 is formed on the capacitor dielectric layer 10.

Furthermore, a third interlayer insulator film 12 is formed to cover the whole surface of the substrate, and the second wiring layer 13 is formed and patterned on the third interlayer insulator film 12. In addition, a fourth interlayer insulator film 14 is formed to cover the whole surface of the substrate, and the third wiring layer 15 is formed and patterned on the fourth interlayer insulator film 14. Finally, a cover film 16 is formed on the whole surface of the substrate. Thus, the semiconductor memory shown in Fig. 1 is completed.

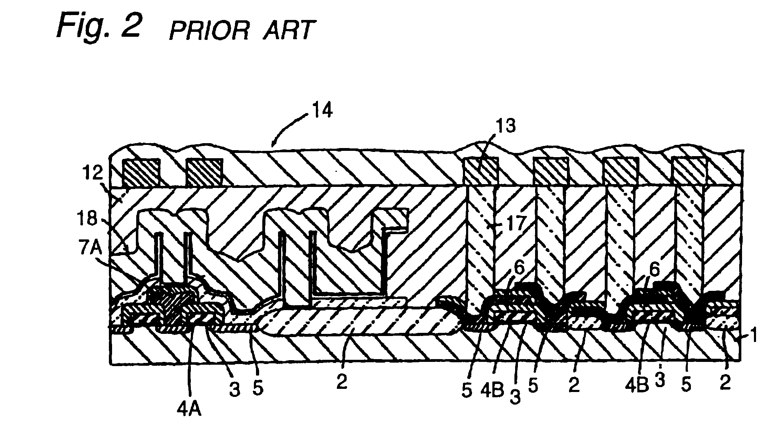

Referring to Fig. 2, there is shown a diagrammatic sectional view of a second example of the prior art semiconductor memory, which is proposed by Japanese Patent Application Pre-examination Publication No. JP-A-04-010651 and its corresponding U.S. Patent 5,218,219 (the content of which is incorporated by reference in its entirety into this application). In Fig. 2, elements similar to those shown in Fig. 1 are given the same Reference Numerals, and explanation thereof will be omitted for simplification of description.

The semiconductor memory of the second prior art example is featured in that a contact layer 17 is formed in only the peripheral circuit zone. The semiconductor memory of the second prior art example is manufactured by forming a capacitor 18 in the memory cell array zone, and then, forming an interlayer insulator film 12 on the whole surface of the substrate, and forming the contact layer 17 in only the peripheral circuit zone, and thereafter, forming the wiring layer 13 in the memory cell array zone and in the peripheral circuit zone.

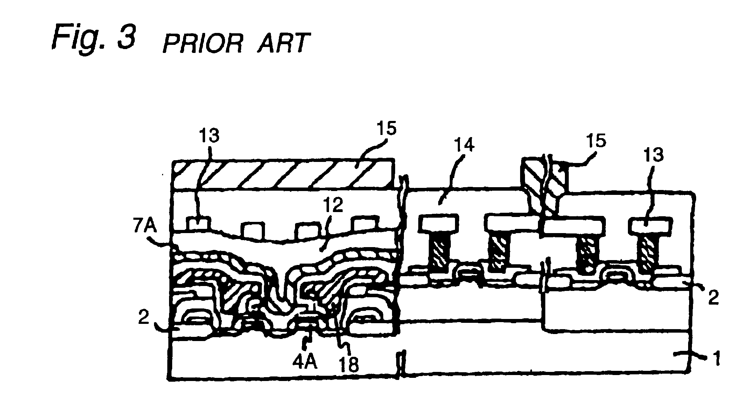

Referring to Fig. 3, there is shown a diagrammatic sectional view of a third example of the prior art semiconductor memory, which is proposed by Japanese Patent Application Pre-examination Publication No. JP-A-04-342166, (an English abstract of which is available from the Japanese Patent Office, and the content of the English abstract of JP-A-04-342166 is incorporated by reference in its entirety into this application). The semiconductor memory of the third prior art example is featured in that the substrate in the memory cell array zone is previously thinned by a difference in height between the memory cell array zone and the peripheral circuit zone, so that when aluminum wiring conductors 13 and 15 are formed, a step of an underlying layer becomes small. The semiconductor memory of the third prior art example is manufactured by excavating or milling down the surface of the substrate in the memory cell array zone before the word line 4A, the capacitor 18, the bit line 7A and others are formed on the silicon substrate 1, and thereafter, forming the word line 4A, the capacitor 18, the bit line 7A and others in order.

Various problems have been encountered in the above mentioned prior art semiconductor memories.

A first problem is that, in the first prior art semiconductor memory shown in Fig. 1, when the second wiring layer 13 is patterned by a lithography using a photoresist, a focal shift occurs because of a step or difference in height generated at a boundary between the memory cell array zone and the peripheral circuit zone.

A second problem is that, in the first prior art semiconductor memory shown in Fig. 1, in order to planarize the interlayer insulator film 14, when the interlayer insulator film 14 in the peripheral circuit zone is made as thin as possible so that the aspect ratio of the contact hole interconnecting the second wiring layer 13 and the third wiring layer 15 in the peripheral circuit zone becomes good, the second wiring layer 13 in the memory cell array zone is often exposed. This is also attributable to the step or difference in height generated at the boundary between the memory cell array zone and the peripheral circuit zone, similarly to the first problem.

A third problem is that, in the second prior art semiconductor memory shown in Fig. 2, since the contact layer 17 must be of a buried plug type, the manufacturing process inevitably becomes complicated. The reason for this is that, after the capacitor 18 is formed, when the interlayer insulator film 12 is formed to planarize the memory cell array zone and the peripheral circuit zone as the whole, the thickness of the interlayer insulator film 12 in the peripheral circuit zone inevitably becomes large.

A fourth problem is that, in the third prior art semiconductor memory shown in Fig. 3, since the surface of the substrate in the memory cell array zone is excavated or milled down by a difference in height between the memory cell array zone and the peripheral circuit zone, the manufacturing process inevitably becomes complicated. The reason for this is that, it is necessary to add a lithography process using a photoresist for excavating or milling down the surface of the substrate before the word line 4A, the capacitor 18, the bit line 7A and others are formed on the silicon substrate 1.

### Summary of the Invention

Accordingly, it is an object of the present invention to provide a semiconductor memory of a stacked capacitor type and a method for manufacturing the same, which have overcome the above mentioned defects of the conventional ones.

Another object of the present invention is to provide a semiconductor memory of a stacked capacitor type and a method for manufacturing the same, which can eliminate the focal shift in a lithography process using a photoresist, which would have otherwise been caused by a step or difference in height at a boundary between a memory cell array zone and a peripheral circuit zone.

Still another object of the present invention is to provide a semiconductor memory of a stacked capacitor type and a method for manufacturing the same, which can prevent the interlayer insulator film in the peripheral circuit zone from becoming thick, and therefore, can avoid the aspect ratio of a contact hole formed in the interlayer insulator film in the peripheral circuit zone from becoming severe, when the memory cell array zone and the peripheral circuit zone are planarized as a whole by forming the interlayer insulator film to eliminate the step or difference in height at a boundary between the memory cell array zone and the peripheral circuit zone.

The above and other objects of the present invention are achieved in accordance with the present invention by a semiconductor memory including a memory cell array zone and a peripheral circuit zone formed on the same semiconductor substrate, and an interlayer insulating layer extending over both the memory cell array zone and the peripheral circuit zone, the memory cell array zone including a plurality of memory cells each having a stacked capacitor, the stacked capacitor being formed of a capacitor dielectric film sandwiched between a capacitor lower electrode and a capacitor upper electrode, the stacked capacitor being formed only in the memory cell array zone, the peripheral circuit zone including a conducting layer formed on only a portion of the interlayer insulating layer within the peripheral circuit zone.

In an embodiment, the conductive layer has a single layer structure or a multi-layer structure. The conductive layer of the single layer structure is formed of tungsten. The conductive layer of the multi-layer structure is formed of tungsten and a barrier metal, or tungsten, a barrier metal and a refractory metal.

Specifically, the semiconductor memory is formed to fulfill the relation of b≥a:
where
"a" is a height of a top surface of the stacked capacitor from a principal surface of the semiconductor substrate, and
"b" is a height of a top surface of the conducting layer from the principal surface of the semiconductor substrate.

In addition, a gate electrode of a switching transistor formed in the memory cell array zone and connected to a corresponding stacked capacitor is formed of polycide or a refractory metal or a refractory metal compound.

According to another aspect of the present invention, there is provided a method for manufacturing a semiconductor memory including a memory cell array zone and a peripheral circuit zone formed on the same semiconductor substrate, the method including the steps of:
forming a field oxide film on a principal surface of a semiconductor substrate to confine a memory cell array zone and a peripheral circuit zone separately from each other, on the principal surface of the semiconductor substrate;
forming a gate electrode functioning as a word line on the principal surface of the semiconductor substrate within the memory cell array zone and a pair of diffused regions in the semiconductor substrate within the memory cell array zone;
forming a first interlayer insulator film on the whole surface, forming a first contact hole to penetrate the first interlayer insulator film to reach one of the pair `of diffused regions, and forming a first wiring layer which fills the first contact hole and which acts as a bit line;
forming a second interlayer insulator film in the memory cell array zone, forming a second contact hole to penetrate the second and first interlayer insulator films to reach the other of the pair of diffused regions, and forming a lower capacitor electrode which fills the second contact hole, and forming a capacitor dielectric film and an upper capacitor electrode on the lower capacitor electrode, thereby to form a stacked capacitor;
forming a third interlayer insulator film on the whole surface including the memory cell array zone and the peripheral circuit zone, and forming a second wiring layer on the third interlayer insulator film only within the peripheral circuit zone, and
forming a fourth interlayer insulator film on the whole surface including the memory cell array zone and the peripheral circuit zone, forming a third contact hole to penetrate the fourth interlayer insulator film within the peripheral circuit zone, and forming a third wiring layer to fill the third contact hole.

Specifically, the fourth interlayer insulator film is formed by depositing a TEOSBPSG (tetraethoxysilane (Si(OC₂H₅)₄) borophosphosilicate glass) film having a film thickness of not less than 5000Å, heat-treating for reflow, and planarizing the TEOSBPSG film by an etching-back. Alternatively, the fourth interlayer insulator film is planarized by a chemical mechanical polishing.

With the above mentioned arrangement, the wiring layer provided in the memory cell array zone to be electrically connected to the gate electrode (word line) through contact holes provided at suitable intervals (namely, backing conducting layer) is abolished, and the wiring layer is provided only in the peripheral circuit zone, so that a boundary region between the memory cell array zone and the peripheral circuit zone is planarized, and the difference in height between the memory cell array zone and the peripheral circuit zone is minimized. Thus, it is possible to eliminate a focus shift which would have otherwise occurred in a lithography process using the photoresist, at the time of forming the wiring layer. Furthermore, when the memory cell array zone and the peripheral circuit zone are planarized as a whole, it is possible to sufficiently thin the film thickness of the interlayer insulator film in the peripheral circuit zone, and therefore, the aspect ratio (depth/width) of a contact hole formed to penetrate through the interlayer insulator film in the peripheral circuit zone can become good or sufficiently small.

In the prior art, the gate electrode (word line) was formed of polysilicon, and was electrically connected, through contact holes formed at intervals corresponding to some number of bits, to the backing wiring layer which is formed in the same pitch as that of the word line, in order to reduce the resistance of the word line. With recent advanced etching technology, since the gate electrode can be formed of a polycide (stacked structure of polysilicon and silicide ), or a refractory metal or a refractory metal compound, the resistance of the gate electrode (word line) can be sufficiently reduced by only the gate electrode (word line), and therefore, the backing wiring layer can be removed from the memory cell array zone.

The above and other objects, features and advantages of the present invention will be apparent from the following description of preferred embodiments of the invention with reference to the accompanying drawings.

### Brief Description of the Drawings

Fig. 1 is a diagrammatic sectional view of a first example of the prior art semiconductor memory;
Fig. 2 is a diagrammatic sectional view of a second example of the prior art semiconductor memory;
Fig. 3 is a diagrammatic sectional view of a third example of the prior art semiconductor memory;
Figs. 4 to 10 are diagrammatic sectional views illustrating a process in accordance with the present invention for manufacturing a first embodiment of the semiconductor memory in accordance with the present invention; and
Fig. 11 is a diagrammatic sectional view of a second embodiment of the semiconductor memory in accordance with the present invention.

### Description of the Preferred embodiments

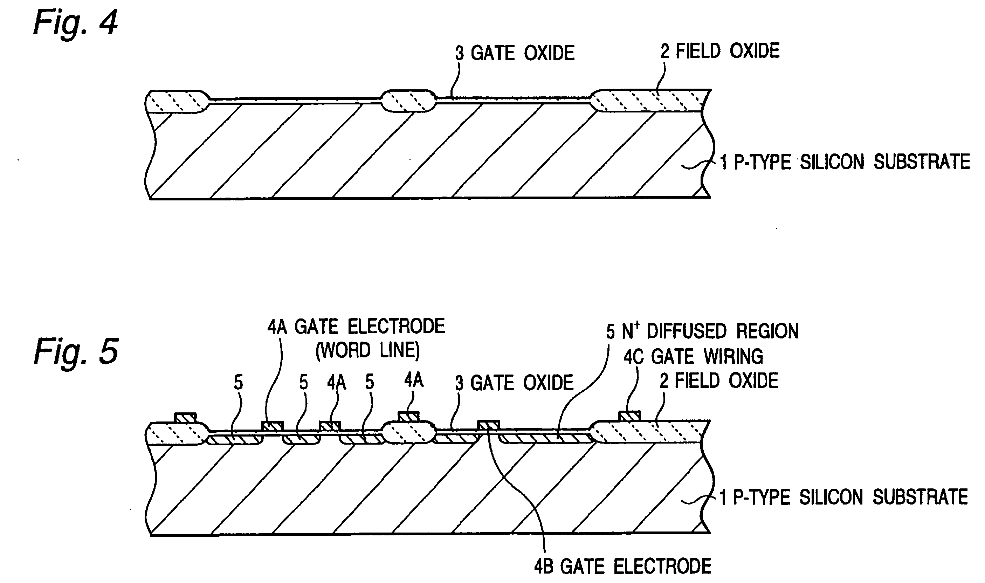

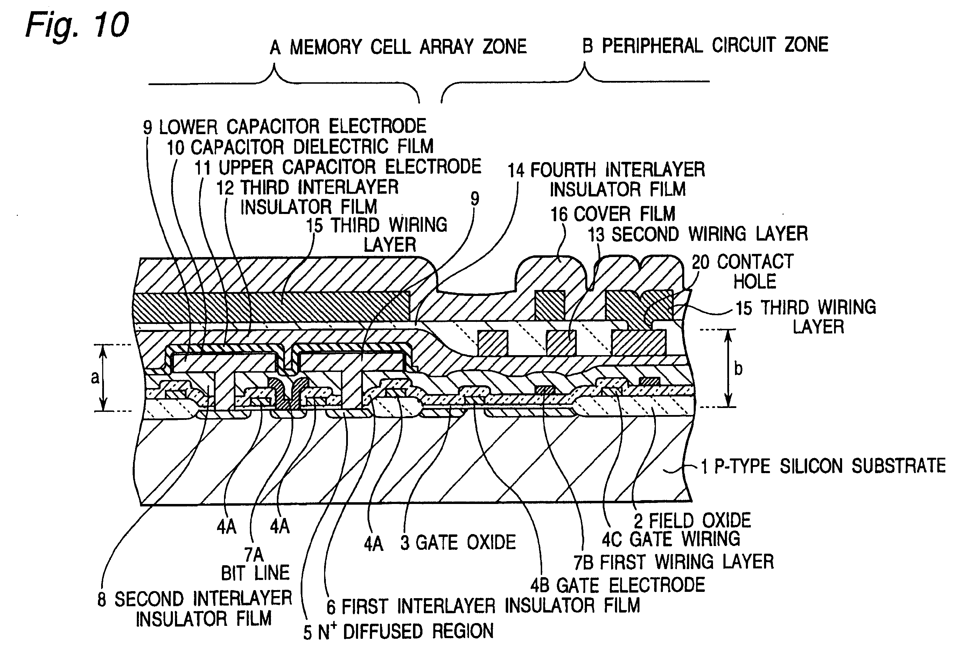

Referring to Figs. 4 to 10, there are shown diagrammatic sectional views illustrating a process in accordance with the present invention for manufacturing a first embodiment of the semiconductor memory in accordance with the present invention. In Figs. 4 to 10, elements similar to those shown in Figs. 1 to 3 are given the same Reference Numerals. The diagrammatic sectional view of Fig. 10 shows the structure of the first embodiment of the semiconductor memory in accordance with the present invention.

As shown in Fig. 10, the first embodiment of the semiconductor memory in accordance with the present invention includes a memory cell array zone "A" and a peripheral circuit zone "B" which are confirmed on a P-type silicon substrate 1. Only in the memory cell array zone "A", for each memory cell, there is formed a stacked capacitor constituted of a capacitor dielectric film 10 sandwiched between a lower capacitor electrode 9 and an upper capacitor electrode 11. Only in the peripheral circuit zone "B", a second wiring layer (conducting layer) 13 is formed. An interlayer insulator film 14 covering the second wiring layer is formed on both the memory cell array zone and the peripheral circuit zone to planarize the memory cell array zone and the peripheral circuit zone as a whole, thereby to make small the aspect ratio of a contact hole formed through the interlayer insulator film 14 for interconnecting between the second wiring layer 13 and a third wiring layer 15 formed on the interlayer insulator film 14.

A conducting layer, constituting the second wiring layer 13, is formed of for example tungsten or aluminum, and can be of a single layer structure or a multi-layer structure.

For example, the conducting layer of the single layer structure can be formed of a tungsten layer or an aluminum layer. The conducting layer of the multi-layer structure can be formed of stacked layers composed of, for example, a tungsten layer and a barrier metal layer, or a tungsten layer, a barrier metal layer and a refractory metal layer, or an aluminum layer and a barrier metal layer, or an aluminum layer, a barrier metal layer and a refractory metal layer. Alternatively, the conducting layer of the multi-layer structure can be formed of stacked layers composed of, for example, a tungsten layer, an aluminum layer and a barrier metal layer, or a tungsten layer, an aluminum layer, a barrier metal layer and a refractory metal layer. However, the conducting layer of the multi-layer structure is in no way limited to the above listed examples. The barrier metal layer can be exemplified by titanium nitride (TiN), and the refractory metal layer can be exemplified by titanium (Ti).

Furthermore, and importantly, assuming that the height of a top surface of the stacked capacitor from the principal surface of the substrate 1 is "a", and the height of a top surface of the second wiring layer 13 from the principal surface of the substrate 1 is "b", "a" and "b" come under the relation of b≥a.

In addition, the gate electrode (word line) 4A provided in the memory cell array zone "A" is formed of a polycide, a refractory metal, or a refractory metal compound.

Now, a process in accordance with the present invention for manufacturing the above mentioned first embodiment of the semiconductor memory in accordance with the present invention will be described with reference to Figs. 4 to 10.

First, as shown in Fig. 4, on the P-type silicon substrate 1, the field oxide film 2 is selectively formed to have a film thickness of 4000Å to 5000Å, and then, the gate oxide film 2 having a film thickness of 100Å to 150Å is formed.

Succeedingly, as shown in Fig. 5, a polysilicon film having a film thickness of 2000Å to 3000Å is deposited on the whole surface of the substrate, and then, is patterned to form gate electrodes (word lines) 4A in the memory cell array zone and a gate electrode 4B and a gate wiring conductor 4C in the peripheral circuit zone. By using the gate electrodes 4A and 4B and the field oxide film 2 as a mask, N-type impurity ions (for example, As ions) are ion-implanted into the substrate to form N⁺ diffused regions 5.

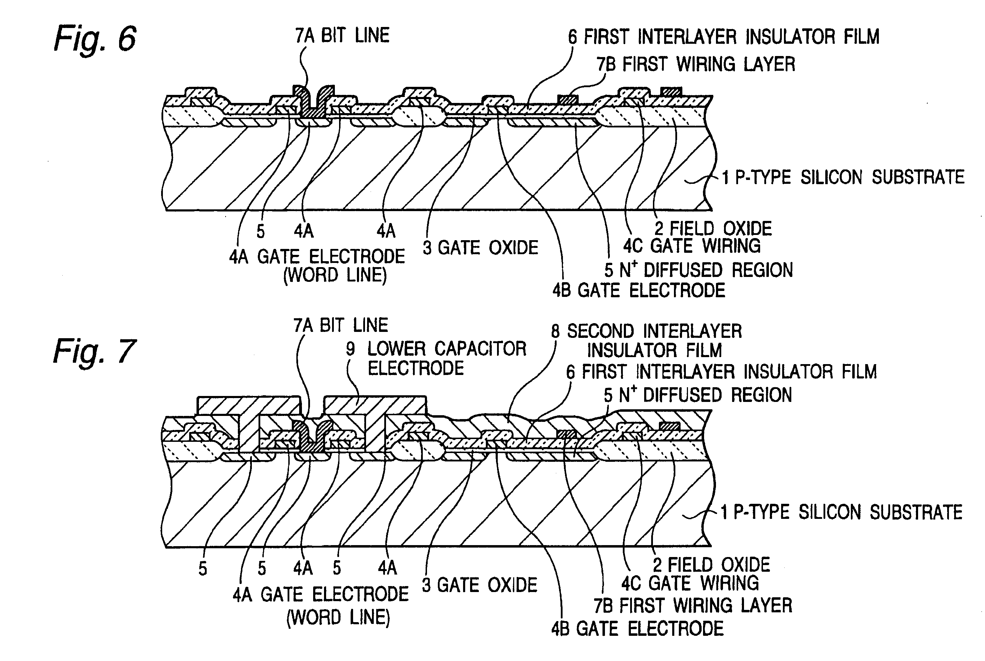

Then, as shown in Fig. 6, a first interlayer insulator film 6 having a film thickness of 3000Å to 4000Å is formed on the whole surface of the substrate. Further, a bit contact hole is formed to penetrate through the first interlayer insulator film 6 and to reach one of a pair of N⁺ diffused regions 5 for each one switching transistor in the memory cell array zone. Thereafter, tungsten silicide (WSi) is deposited on the whole surface of the substrate by sputtering to have a film thickness of 2000Å to 3000Å, and then, the deposited tungsten silicide film is patterned to form the bit line 7A in the memory cell array zone and the first wiring layer 7B in the peripheral circuit zone.

Furthermore, as shown in Fig. 7, a second interlayer insulator film 8 having a film thickness of 4000Å to 5000Å is formed on the whole surface of the substrate. Further, a contact hole is formed to penetrate through the second interlayer insulator film 8 and the first interlayer insulator film 6 and to reach the other of the pair of N⁺ diffused regions 5 for each one switching transistor in the memory cell array zone. A polysilicon film having a film thickness of 3000Å to 4000Å are formed to fill the contact hole just formed, and then, is patterned to form the lower capacitor electrode 9. Thus, the lower capacitor electrode 9 composed of polysilicon is formed in electrical connection with the other of the pair of N⁺ diffused regions 5 for the switching transistor of each memory cell.

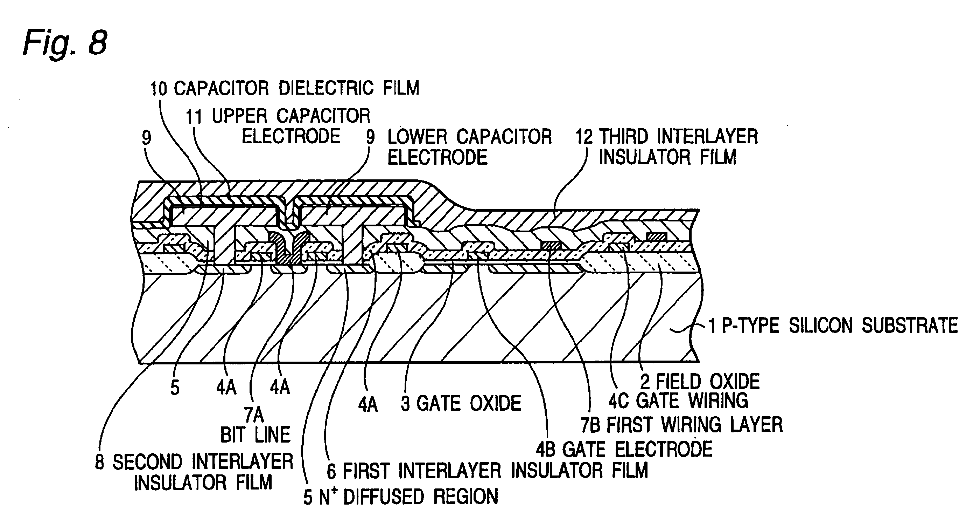

Then, as shown in Fig. 8, the capacitor dielectric film 10 is formed to cover the lower capacitor electrode 9. This capacitor dielectric film 10 has a film thickness of 60Å to 80Å in an oxide film thickness conversion. The upper capacitor electrode 11 is formed to cover the capacitor dielectric film 10. This upper capacitor electrode 11 is formed of a polysilicon film having a film thickness of 1000Å to 2000Å. In addition, a third interlayer insulator film 12 having a film thickness of 4000Å to 5000Å is formed on the whole surface of the substrate.

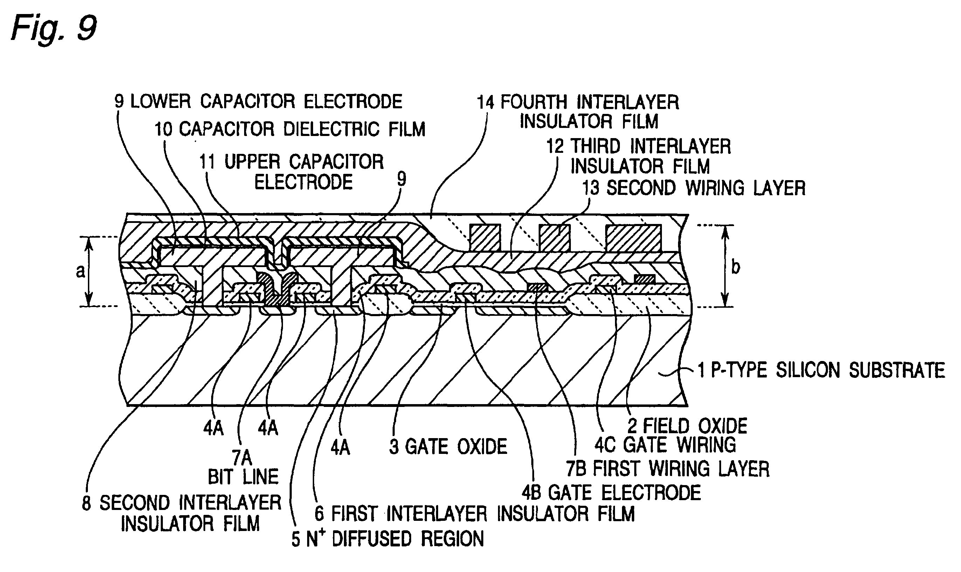

Furthermore, as shown in Fig. 9, aluminum is deposited on the whole surface of the substrate by sputtering to have a film thickness of 4000Å to 5000Å, and then, the deposited aluminum film is patterned to form the second wiring layer 13 only in the peripheral circuit zone. At this time of patterning the deposited aluminum film to form the second wiring layer 13, the focus margin is improved by 0.8 µm to 1.0 µm, in comparison with the prior art example in which the wiring layer was formed over both the memory cell array zone and the peripheral circuit zone.

This is considered that, since there is a step or difference in surface height between the memory cell array zone and the peripheral circuit zone before the second wiring layer 13 is formed, the prior art example was required to focus to both the memory cell array zone and the peripheral circuit zone in the photolithography process. In this embodiment, however, since the second wiring layer 13 is formed only in the peripheral circuit zone, it is sufficient if the focusing is made only in the peripheral circuit zone.

Succeedingly, as shown in Fig. 9, a fourth interlayer insulator film 14 having a film thickness of 8000Å to 10000Å is formed on the whole surface of the substrate, and the whole surface of the fourth interlayer insulator film 14 is planarized by an etching back using a wet etching, or a chemical mechanical polishing (CMP). For example, the fourth interlayer insulator film 14 is formed by depositing a TEOSBPSG film having a film thickness of 8000Å to 10000Å, and then by heat-treating the TEOSBPSG film for reflow, and further by planarizing the TEOSBPSG film by the etching back using the wet etching. In place of the etching back using the wet etching, the TEOSBPSG film can be planarized by the chemical mechanical polishing (CMP).

Here, assuming that the height of a top surface of the upper capacitor electrode 11 from the principal surface of the substrate 1 is "a", and the height of a top surface of the second wiring layer 13 from the principal surface of the substrate 1 is "b", if the process is controlled (for example, the thickess of the second wiring layer 13 is determined) to meet the relation of b≥a, the film thickness of the fourth interlayer insulator film 14 above the second wiring layer 13 can be sufficiently reduced with no possibility that the upper capacitor electrode 11 is exposed from the interlayer insulator film 12.

Finally, as shown in Fig. 10, a contact hole 20 is formed to penetrate through the fourth interlayer insulator film 14 and to reach the second wiring layer 13, and then, aluminum is deposited on the whole surface of the substrate by sputtering to have a film thickness of 8000Å to 10000Å and to fill the contact hole 20. Then, the deposited aluminum film is patterned to form the third wiring layer 15 on the fourth interlayer insulator film 14. Thereafter, a cover film 16 having a film thickness of 8000Å to 10000Å is formed on the whole surface of the substrate. Thus, the semiconductor memory of the first embodiment is completed.

As mentioned above, by forming the second wiring layer 13 only in the peripheral circuit zone, when the fourth interlayer insulator film 14 is formed to cover both the memory cell array zone and the peripheral circuit zone and is then planarized, it is possible to sufficiently thin the film thickness of the fourth interlayer insulator film 14 above the second wiring layer 13 in the peripheral circuit zone, and therefore, the aspect ratio (depth/width) of the contact hole 20 interconnecting between the second wiring layer 13 and the third wiring layer 15 can become good or sufficiently small, and also, the coverage of the third wiring layer 15 filling the contact 20 becomes good.

Furthermore, when the fourth interlayer insulator film 14 is planarized, the upper capacitor electrode 11 is in no way exposed. In addition, at the time of forming the second wiring layer 13 after the upper capacitor electrode 11 is formed, a focus shift does not occur in a lithography process using the photoresist. Furthermore, since the fourth interlayer insulator film 14 is sufficiently planarized, no focus shifting occurs in a lithography process using the photoresist for purpose of forming the third wiring layer 15.

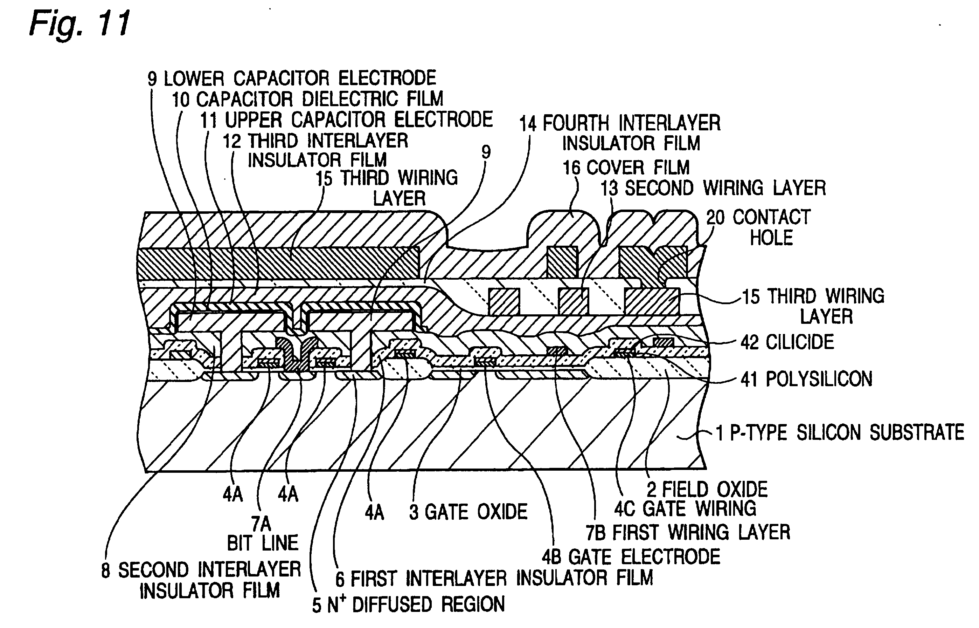

Referring to Fig. 11, there is shown a diagrammatic sectional view of a second embodiment of the semiconductor memory in accordance with the present invention. In Fig. 11, elements similar to those shown in Figs. 1 to 3 and 10 are given the same Reference Numerals.

As seen from comparison between Figs. 10 and 11, the second embodiment of the semiconductor memory is different from the first embodiment of the semiconductor memory only in that the gate electrodes (word lines) 4A in the memory cell array zone and the gate electrode 4B and the gate wiring conductor 4C in the peripheral circuit zone are formed of a stacked structure of a polysilicon and silicide (namely, polycide) or alternatively a refractory metal or its compound. This polycide can be exemplified by WSi₂/polySi and TiSi₂/polySi. The refractory metal layer can be exemplified by titanium (Ti), and the refractory metal compound can be exemplified by titanium nitride (TiN).

Therefore, the second embodiment is common to the first embodiment in that, only in the memory cell array zone, there is formed the stacked capacitor constituted of the capacitor dielectric film 10 sandwiched between the lower capacitor electrode 9 and the upper capacitor electrode 11, and on the other hand, only in the peripheral circuit zone, the second wiring layer (conducting layer) 13 is formed, and in that the interlayer insulator film 14 covering the second wiring layer is formed on both the memory cell array zone and the peripheral circuit zone to planarize the memory cell array zone and the peripheral circuit zone as a whole, thereby to make small the aspect ratio of a contact hole formed through the interlayer insulator film 14 for interconnecting between the second wiring layer 13 and the third wiring layer 15 formed on the interlayer insulator film 14.

Now, a process in accordance with the present invention for manufacturing the second embodiment of the semiconductor memory in accordance with the present invention will be described with reference to Fig. 11.

On the P-type silicon substrate 1, the field oxide film 2 is selectively formed to have a film thickness of 4000Å to 5000Å, and then, the gate oxide film 2 having a film thickness of 100Å to 150Å is formed. Succeedingly, a polysilicon film 41 having a film thickness of 1000Å to 2000Å is deposited on the whole surface of the substrate, and then, tungsten silicide (WSi) 42 is deposited on the whole surface of the deposited polysilicun film 41 by sputtering to have a film thickness of 1000Å to 2000Å. The stacked layer of the polysilicon film 41 and the tungsten silicide film 42 (namely, polycide) is patterned to form the gate electrodes (word lines) 4A in the memory cell array zone and the gate electrode 4B and the gate wiring conductor 4C in the peripheral circuit zone. Therefore, each of the gate electrodes (word lines) 4A, the gate electrode 4B and the gate wiring conductor 4C is formed of the stacked structure of the polysilicon film having the film thickness of 1000Å to 2000Å and the tungsten silicide (WSi) film having the film thickness of 1000å to 2000Å. The succeeding process of the second embodiment is the same as that of the first embodiment, so that the semiconductor memory of the second embodiment is completed as shown in Fig. 11.

In the second embodiment, since the gate electrodes (word lines) 4A, the gate electrode 4B and the gate wiring conductor 4C are formed of the stacked structure of the polysilicon and the tungsten silicide, (namely, polycide) as mentioned above, or alternatively, of a refractory metal or a refractory metal compound (not shown), the resistance of the gate electrodes 4A and 4B and the gate wiring conductor 4C can be reduced to a sufficiently low value. Therefore, even if there is removed the second wiring layer 13 provided in the memory cell array zone and electrically connected to the gate electrode (word line) 4A through contact holes formed at regular intervals for the purpose of reducing the resistance of the gate electrode (word line) 4A, it is possible to prevent increase of the resistance of the gate electrode (word line) 4A.

As mentioned above, by abolishing the second wiring layer 13 in the memory cell array zone and by forming the second wiring layer 13 only in the peripheral circuit zone, it is possible to eliminate a focus shift which would have otherwise occurred in a lithography process using the photoresist, at the time of forming the second wiring layer 13 after the upper capacitor electrode 11 is formed, and in addition, at the time of planarizing the fourth interlayer insulator film 14, it is possible to sufficiently thin the film thickness of the fourth interlayer insulator film 14 above the second wiring layer 13, with no possibility that the second wiring layer 13 or the upper capacitor electrode 11 is exposed.

Accordingly, without adding a lithography process using a new photoresist pattern, and without making the process complicated, the aspect ratio (depth/width) of the contact hole 20 interconnecting between the second wiring layer 13 and the third wiring layer 15 can become good or sufficiently small, and also, the coverage of the third wiring layer 15 filling the contact 20 becomes good. Furthermore, since the fourth interlayer insulator film 14 is sufficiently planarized, no focus shifting occurs in a lithography process using the photoresist for purpose of forming the third wiring layer 15.

In addition, when the conductive layer is formed of tungsten, it is possible to effectively fill the contact hole with the conductive layer. Furthermore, if the conductive layer is formed of a stacked structure of tungsten and a barrier metal, or tungsten, a barrier metal and a refractory metal, the resistance of the conductive layer can be sufficiently reduced.

The invention has thus been shown and described with reference to the specific embodiments. However, it should be noted that the present invention is in no way limited to the details of the illustrated structures but changes and modifications may be made within the scope of the appended claims.

## Claims

1. A semiconductor memory including a memory cell array zone and a peripheral circuit zone formed on the same semiconductor substrate, and an interlayer insulating layer extending over both said memory cell array zone and said peripheral circuit zone, the memory cell array zone including a plurality of memory cells each having a stacked capacitor, said stacked capacitor being formed of a capacitor dielectric film sandwiched between a capacitor lower electrode and a capacitor upper electrode, said stacked capacitor being formed only in said memory cell array zone, said peripheral circuit zone including a conducting layer formed on only a portion of said interlayer insulating layer within said peripheral circuit zone.

2. A semiconductor memory claimed in Claim 1 wherein said conductive layer has a single layer structure or a multi-layer structure.

3. A semiconductor memory claimed in Claim 2 wherein said conductive layer of the single layer structure is formed of tungsten.

4. A semiconductor memory claimed in Claim 2 wherein said conductive layer of the multi-layer structure is formed of tungsten and a barrier metal or tungsten, a barrier metal and a refractory metal.

5. A semiconductor memory claimed in Claim 1 wherein the relation of b≥a is fulfilled:
where
"a" is a height of a top surface of said stacked capacitor from a principal surface of said semiconductor substrate,
and
"b" is a height of a top surface of said conducting layer from the principal surface of said semiconductor substrate.

6. A semiconductor memory claimed in Claim 1 wherein a gate electrode of a switching transistor formed in said memory cell array zone and connected to a corresponding stacked capacitor is formed of polycide or a refractory metal or a refractory metaI compound.

7. A method for manufacturing a semiconductor memory including a memory cell array zone and a peripheral circuit zone formed on the same semiconductor substrate, the method including the steps of:
forming a field oxide film on a principal surface of a semiconductor substrate to confine a memory cell array zone and a peripheral circuit zone separately from each other, on said principal surface of said semiconductor substrate;
forming a gate electrode functioning as a word line on said principal surface of said semiconductor substrate within said memory cell array zone and a pair of diffused regions in said semiconductor substrate within said memory cell array zone;
forming a first interlayer insulator film on the whole surface, forming a first contact hole to penetrate said first interlayer insulator film to reach one of said pair of diffused regions, and forming a first wiring layer which fills said first contact hole and which acts as a bit line;
forming a second interlayer insulator film in said memory cell array zone, forming a second contact hole to penetrate said second and first interlayer insulator films to reach the other of said pair of diffused regions, and forming a lower capacitor electrode which fills said second contact hole, and forming a capacitor dielectric film and an upper capacitor electrode on said lower capacitor electrode, thereby to form a stacked capacitor;
forming a third interlayer insulator film on the whole surface including said memory cell array zone and said peripheral circuit zone, and forming a second wiring layer on said third interlayer insulator film only within said peripheral circuit zone, and
forming a fourth interlayer insulator film on the whole surface including said memory cell array zone and said peripheral circuit zone, forming a third contact hole to penetrate said fourth interlayer insulator film within said peripheral circuit zone, and forming a third wiring layer to fill said third contact hole.

8. A method claimed in Claim 7 wherein said fourth interlayer insulator film is formed by depositing a TEOSBPSG film having a film thickness of not less than 5000Å, heat-treating for reflow, and planarizing said TEOSBPSG film by an etching-back.

9. A method claimed in Claim 7 wherein said fourth interlayer insulator film is planarized by a chemical mechanical polishing.
